(19) Europäisches Patentamt
European Patent Office
Office européen des brevets

(11) **EP 2 924 821 B1**

(12) **EUROPEAN PATENT SPECIFICATION**

(45) Date of publication and mention
of the grant of the patent:
**25.04.2018 Bulletin 2018/17**

(51) Int Cl.:
*H01S 5/024* (2006.01)   *H01S 5/06* (2006.01)
*G01N 21/3504* (2014.01)   *G01N 21/39* (2006.01)

(21) Application number: **15160665.4**

(22) Date of filing: **24.03.2015**

(54) **A TUNING SYSTEM FOR A TUNEABLE DIODE LASER SPECTROSCOPY DEVICE COMPRISING A THERMO ELECTRIC COOLER AND A STIRLING COOLER**

ABSTIMMSYSTEM FÜR ABSTIMMBARE DIODENLASERSPEKTROSKOPIEVORRICHTUNG MIT EINEM THERMOELEKTRISCHEN KÜHLER UND EINEM STIRLING-KÜHLER

SYSTÈME DE SYNTONISATION POUR UN DISPOSITIF DE SPECTROSCOPIE À DIODE LASER SYNTONISABLE COMPRENANT UN REFROIDISSEUR THERMOÉLECTRIQUE ET UN REFROIDISSEUR À CYCLE DE STIRLING

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2014 GB 201405436**

(43) Date of publication of application:
**30.09.2015 Bulletin 2015/40**

(73) Proprietor: **Michell Instruments Ltd.**
**Ely, Cambridgeshire CB6 3NW (GB)**

(72) Inventors:
• **Stokes, Andrew M. V.**
**Bottisham, Cambridgeshire CB25 9TA (GB)**
• **Summers, Michael**
**Ely, Cambridgeshire CB7 4BA (GB)**
• **Page, Hideaki**
**Cottenham, Cambridgeshire CB24 8TG (GB)**

(74) Representative: **Gill Jennings & Every LLP**
**The Broadgate Tower**
**20 Primrose Street**
**London EC2A 2ES (GB)**

(56) References cited:
WO-A1-2009/116132   JP-A- 2002 353 551
JP-A- 2006 277 417   JP-A- 2007 088 266
JP-A- 2011 119 342   US-A- 5 615 052

## Description

The present invention relates to laser spectroscopy, and more particularly, to a Laser Thermal Tuning System (LTTS) and a resulting multi-species spectroscopic analyser comprising the LTTS, wherein the output wavelength of the LTTS may be accurately controlled and the range of accessible wavelengths increased for the tuneable element of the LTTS.

Laser spectroscopy is a well-known and established measurement technique which uses the fundamental absorption of light by gases and liquids which is known to occur at characteristic wavelengths in order to accurately determine the concentration of the various components present in said gas or liquid mixture.

There are many well-known spectroscopy techniques. Examples include direct absorption spectroscopy (DAS), wavelength modulated spectroscopy (WMS), frequency modulated spectroscopy (FMS), cavity enhanced absorption spectroscopy (CEAS), and photo acoustic spectroscopy (PAS), amongst others. Most are generically referred to as tuneable diode laser absorption spectroscopy (TDLAS) techniques.

A fundamental limitation of such TDLAS techniques is that the lasers, from whatever laser technology they are sourced, are manufactured to produce light of a specific wavelength and therefore only work over a limited spectral range. Accordingly, spectroscopic detection systems may be broadly divided into two categories: broadband, low resolution systems; and narrow band, high resolution systems.

The following examples are given to illustrate the problem: Fourier Transform Infrared Spectrometry (FTIR) employs a black body source to generate a wide spectrum of wavelengths covering the infrared portion of the electromagnetic spectrum. This allows many absorption bands of different molecules to be detected. However, high resolution measurements with an FTIR are challenging, and fine spectral detail is lost. Conversely, TDLAS has an intrinsic high resolution in the region of several MHz due to the narrow line width of the laser. This allows finer details of the molecular spectra to be resolved but only over a narrow wavelength tuning range that, depending on the specific current tuning characteristic of the laser used, can be approximately 1 nm in the near-infrared. Therefore, although the technique is inherently capable of discriminating the detail needed, the limited spectral range of the lasers used in TDLAS can be seen to be a primary limiting factor preventing such an analyser from being able to detect more than one or perhaps two species of interest for any given laser device. TDLAS analysers are therefore usually applied to single molecular species detection.

Furthermore, real samples to be analysed are complex, typically containing several molecular species that have overlapping spectral features and therefore detection and discrimination of, and between, these compositional elements of the sample is convoluted. In summary, the resolution of the FTIR may not be sufficient to separate the interlaced spectral features whereas the narrow tuning range of TDLAS may be insufficient to capture all of the necessary spectroscopic detail over a suitably wide spectral range.

It follows that under the prior art, a TDLAS-based analyser which can detect multiple species therefore usually requires multiple lasers and thus is expensive. However, it is clear that many laboratory and industrial processes require determination of several species simultaneously, so it follows that these applications would benefit from a system that can provide multi-species detection without the use of multiple lasers.

Laser diodes in TDLAS are typically tuned by varying their temperature, either by self-heating by controlling the driving current through the device or by varying the local environmental temperature of the laser. Usually, both methods are used in combination. The local temperature of the laser may be set to centre the tuning window on the spectroscopic region of interest and the current-induced self-heating is then used to provide a rapid tuning sweep. Varying the local temperature over a wider range will increase the tuning window of the laser. Typically, the operating temperature is set to range between 20°C either side of room temperature, extending the tuning range to several nm. It should be noted that in the prior art, increasing the operating temperature significantly above ambient room temperature is not an ideal approach for increasing the tuning range as this leads to a significant decrease in device efficiency.

In some applications of the prior art, lasers have been super-cooled in order to provide significant shifts in their working wavelengths. However, such super-cooling usually requires cryogenic techniques which are expensive, and whilst this may be acceptable in a controlled laboratory environment, it is usually an unacceptable, or unsuitable, technique for continuous operation or for industrial applications where there is an expectation that an analyser will be able to work for periods of many years with minimal user intervention.

Attempts have been made to use cooling techniques in order to increase the spectral range of laser diodes. For example, it has been suggested to use cascaded cooling elements or heat pumps to enhance the efficiency of the system and hence attain low temperatures. However, one problem with using cascaded thermoelectric coolers alone is that the efficiency of thermoelectric coolers is well known to diminish in direct relationship to their operating temperature. This is a particularly limiting factor at temperatures approaching cryogenic levels because if it is to be used to control the laser temperature the thermoelectric cooler must cool against both the ambient heat load as well as the self-heating of the laser. It will be clear to anyone versed in the art that the lower the temperature of the system that is required, the less cooling power there is available to overcome the self-heating of the laser.

Stirling coolers may also be cascaded with thermoelectric coolers to achieve low temperatures. However, a problem with this approach is that fine control of the temperature of the Stirling cooler is difficult to achieve as these are mechanical devices with moving parts. TDLAS typically requires precise temperature control down to as much as a thousandth of a degree Celsius. The Stirling cooler is excellent for rapid cooling, but not as good when used for control. The use of a thermoelectric cooler, or other means, cascaded with the Stirling cooler can rectify this deficiency to a certain extent. However, as the thermoelectric cooler efficiency is diminished at low temperatures, the necessary level of precise temperature stability is hard to achieve. Additional heat loading due to the power dissipation in the laser diode package further exacerbates this problem.

JP 2011 119342 A discloses laser device which includes a plurality of laser diodes supported by a support base, and a laser diode cooling mechanism which cools the plurality of laser diodes. The laser diode cooling mechanism is provided with an installation member as a heat sink, a Peltier element provided between the installation member and the respective laser diodes, and a Stirling cooler which cools the installation member.

Accordingly, there is a need for a low cost TDLAS analyser which has a wide tuning range and which is therefore able to analyse the potentially large number of species that may be present in a sample, or process, without the provision of multiple lasers or a costly and unreliable cooling system, and whilst maintaining a high resolution.

According to the present invention, there is provided a laser thermal tuning system for a tuneable diode laser spectroscopy device, the system comprising: a thermoelectric cooler; a Stirling cooler method via open loop or closed loop; a laser diode arranged between the thermoelectric cooler and the Stirling cooler and coupled to each of the thermoelectric cooler and the Stirling cooler; and control means for controlling each of the thermoelectric cooler and the Stirling cooler, wherein the control means is configured to control the temperature of the laser diode and thereby vary the output wavelength of the laser diode.

With the configuration of the present invention in combination with any suitable spectroscopic technique including, but not limited to, those listed in the preceding sections, it is clearly possible to provide a TDLAS analyser with an analytical wavelength range which is sufficient to analyse a large number of species yet which is low cost and has a long operating life. This may be done at much lower cost than the prior art configurations, given that there is no need to provide cryogenic cooling.

The present invention optimises the accuracy of control of the temperature of the device to be cooled, in particular, at low temperatures where the self-heating of the device makes it difficult to control temperatures accurately. An advantage of the arrangement of the present invention is that broad spectroscopic tuning may be achieved by allowing temperature control from cryogenic to ambient temperatures. Another advantage is that fine control of the temperature may be achieved through optimal operation of the thermoelectric cooler.

Preferably, the LTTS may further comprise a thermal mount. The thermal mount may be arranged to provide an interface from the laser diode to the Stirling cooler. Further, the thermal mount is arranged to provide an interface from the laser diode to the external environment via the thermoelectric cooler. This interface may be further enhanced by the addition of a suitable heat transfer means, such as a heat sink.

In one example, the control means may be configured to control the output of the laser diode to scan over a continuous range of wavelength. In another example, the control means may be configured to control the output of the laser diode to provide scanning at discrete wavelength steps. In yet another example, separate control means may be utilised to provide the functions of controlling the output of the laser diode to scan over a continuous range of wavelengths and/or controlling the output of the laser diode to provide scanning at discrete wavelength steps.

According to the present invention, there is also provided a spectroscopic analyser comprising a laser thermal tuning system according to any preceding claim, and further comprising: an analytical measurement chamber for receiving, in use, a sample to be analysed; and a light receiving component for receiving light from the system that has passed though the sample chamber to determine the nature of the sample.

The analyser of the present invention may be configured to analyse any multi-species composition of interest, examples of which include (but are not limited to): Natural gas; Combustion gases and by-products of combustion processes; Environmental gases including, but not limited to, typical greenhouse gases; Other gases, gas mixtures or liquids where the ability to determine multi-species data would be advantageous. For illustration, in the case of natural gases, the present invention provides advantages over existing analysers in terms of its capability to analyse all or most of the constituent species present in the gas or liquid as well as providing reduced drift and other associated reliability improvements.

According to the present invention, it is also possible to provide a spectroscopic analyser comprising multiple laser thermal tuning systems and multiple control means, one associated with each laser thermal tuning system, such that the resulting increased analytical spectrum that can be provided by the analyser, enables the detection of even more species.

Certain preferred embodiments of the present invention will now be described by way of example only with reference to the accompanying drawings, in which:

Figure 1 is a schematic diagram showing a prior art analyser;

Figures 2a and 2b are a schematic diagrams showing a Laser Thermal Tuning System (LTTS) according to the present invention; and

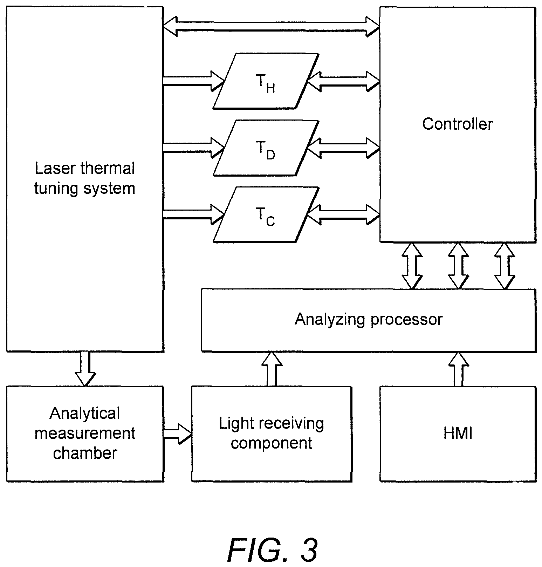

Figure 3 is a schematic diagram showing an analyser according to the present invention.

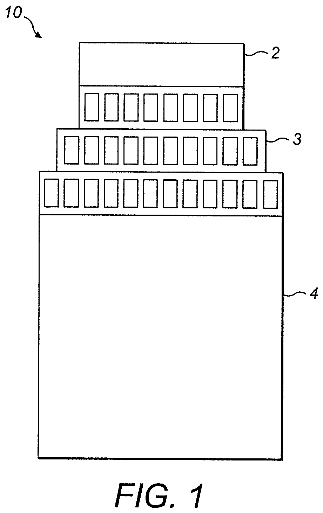

Referring to Figure 1, a system 10 for use in a spectroscopic analyser according to the prior art is shown having a laser diode 2 which is mounted on a thermoelectric cooler 3. This thermoelectric cooler is in turn mounted on a Stirling cooler 4.

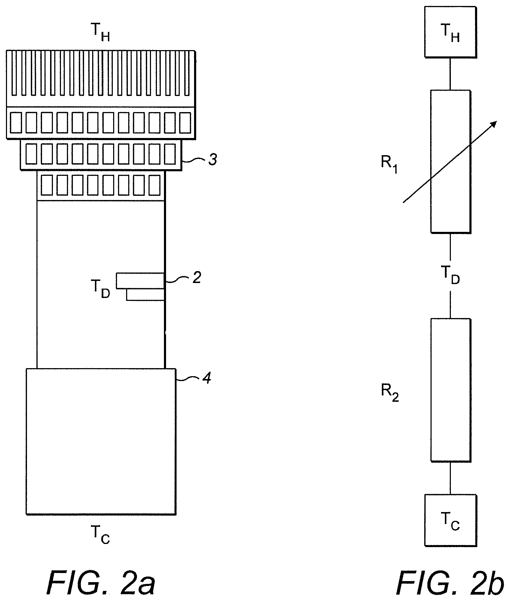

A schematic diagram of the system of the present invention is shown in Figures 2a and 2b, wherein the laser thermal tuning system 20 is analogous to a thermal potential divider 30. Referring to Figure 2B, a thermal analogy 30 of an electrical potential divider circuit is shown. A thermal potential is applied across two resistances, R1 and R2. The potential difference is equivalent to the difference in temperature between $T_H$ and $T_C$. The thermal potential at the junction between the two resistances, $T_D$, is controlled by varying the values of the two thermal resistances according to the following equation:

$$T_D = (T_H - T_C)\frac{R1}{R1 + R2}$$

wherein $T_D$ is the temperature of the device, TH is the external temperature of the ambient air, $T_C$ is the temperature of the cold head of the Stirling cooler, R1 is the thermal resistance of the upper arm of the thermal potential divider and R2 is the thermal resistance of the lower arm of the thermal potential divider.

R1 may be a variable thermal resistance that allows the laser diode temperature, $T_D$ to be controlled accurately using a thermoelectric cooler 3.

## Claims

1. A laser thermal tuning system (10) for a tuneable diode laser spectroscopy device, the system comprising:

   a thermoelectric cooler (3);
   a Stirling cooler (4) controlled via open loop or closed loop control;
   a laser diode (2) arranged between the thermoelectric cooler and the Stirling cooler and coupled to each of the thermoelectric cooler and the Stirling cooler; and
   control means for controlling each of the thermoelectric cooler and the Stirling cooler, wherein the control means is configured to control the temperature of the laser diode and thereby vary the output wavelength of the laser diode.

2. A laser thermal tuning system (10) according to claim 1, wherein the system further comprises a thermal mount.

3. A laser thermal tuning system (10) according to claim 2, wherein the thermal mount is arranged to provide an interface from the laser diode (2) to the Stirling cooler (4).

4. A laser thermal tuning system (10) according to claim 2 or 3, wherein the thermal mount is arranged to provide an interface from the laser diode (2) to the external environment via the thermoelectric cooler (3).

5. A laser thermal tuning system (10) according to any preceding claim, wherein the control means is configured to control the output of the laser diode (2) to scan over a continuous range of wavelengths.

6. A laser thermal tuning system (10) according to any preceding claim, wherein the control means is configured to control the output of the laser diode (2) to provide scanning at discrete wavelength steps.

7. A spectroscopic analyser comprising a laser thermal tuning system (10) according to any preceding claim, and further comprising:

   an analytical measurement chamber for receiving, in use, a sample to be analysed; and
   a light receiving component for receiving light from the system that has passed though the sample chamber to determine the nature of the sample.

## Patentansprüche

1. Ein Thermal-Laserabstimmsystem (10) für eine abstimmbare Diodenlaserspektroskopievorrichtung, wobei das System Folgendes umfasst:

   einen thermoelektrischen Kühler (3);
   einen Stirling-Kühler (4), der über eine rückführungslose Steuerung oder Steuerung mit Rückführung gesteuert wird;
   eine Laserdiode (2), die zwischen dem thermoelektrischen Kühler und dem Stirling-Kühler angeordnet ist und jeweils mit dem thermoelektrischen Kühler und dem Stirling-Kühler verbunden ist; und
   ein Steuermittel zur jeweiligen Steuerung des thermoelektrischen Kühlers und des Stirling-Kühlers, wobei das Steuermittel so konfiguriert sind, dass die Temperatur der Laserdiode steuern und somit die Ausgangswellenlänge der Laserdiode variieren.

**2.** Ein Thermal-Laserabstimmsystem (10) entsprechend Anspruch 1, wobei das System zudem eine thermische Halterung umfasst.

**3.** Ein Thermal-Laserabstimmsystem (10) entsprechend Anspruch 2, wobei die thermische Halterung so angeordnet ist, dass sie eine Schnittstelle von der Laserdiode (2) zum Stirling-Kühler (4) liefert.

**4.** Ein Thermal-Laserabstimmsystem (10) entsprechend Anspruch 2 oder 3, wobei die thermische Halterung so angeordnet ist, dass sie über den thermoelektrischen Kühler (3) eine Schnittstelle von der Laserdiode (2) zur externem Umwelt liefert.

**5.** Ein Thermal-Laserabstimmsystem (10) entsprechend einem der vorhergehenden Ansprüche, wobei das Steuermittel so konfiguriert ist, dass es die Ausgabe der Laserdiode (2) zur Abtastung über einen kontinuierlichen Wellenlängenbereich steuert.

**6.** Ein Thermal-Laserabstimmsystem (10) entsprechend einem der vorhergehenden Ansprüche, wobei das Steuermittel so konfiguriert ist, dass es die Ausgabe der Laserdiode (2) zur Abtastung in separaten Wellenlängenschritten steuert.

**7.** Ein Spektroskopie-Analysegerät, das eine thermales Laserabstimmsystem (10) entsprechend einem der vorhergehenden Ansprüche umfasst, das zudem Folgendes umfasst:

eine Analysemesskammer zur Aufnahme einer zu analysierenden Probe, wenn in Gebrauch; und
eine lichtaufnehmende Komponente zum Empfang von Licht vom System, das die Probenkammer durchlaufen hat, um die Art der Probe zu bestimmen.

**Revendications**

**1.** Système de syntonisation thermique de laser (10) pour un dispositif de spectroscopie laser à diode syntonisable, ce système comprenant :

un refroidisseur thermoélectrique (3) ;
un refroidisseur Stirling (4) commandé au moyen d'une commande en boucle ouverte ou en boucle fermée ;
une diode laser (2) disposée entre le refroidisseur thermoélectrique et le refroidisseur Stirling et couplée à chacun du refroidisseur thermoélectrique et du refroidisseur Stirling ; et
un moyen de commande pour commander chacun du refroidisseur thermoélectrique et du refroidisseur Stirling, ce moyen de commande étant configuré de façon à régler la température de la diode laser et à varier ainsi la longueur d'onde de sortie de la diode laser.

**2.** Système de syntonisation thermique de laser (10) selon la revendication 1, ce système comprenant en outre un support thermique.

**3.** Système de syntonisation thermique de laser (10) selon la revendication 2, le support thermique étant agencé de façon à fournir une interface entre la diode laser (2) et le refroidisseur Stirling (4).

**4.** Système de syntonisation thermique de laser (10) selon la revendication 2 ou 3, le support thermique étant agencé de façon à fournir une interface entre la diode laser (2) et l'environnement extérieur via le refroidisseur thermoélectrique (3).

**5.** Système de syntonisation thermique de laser (10) selon l'une quelconque des revendications précédentes, dans lequel le moyen de commande est configuré de façon à régler la sortie de la diode laser (2) de façon à analyser par balayage sur une gamme continue de longueurs d'onde.

**6.** Système de syntonisation thermique de laser (10) selon l'une quelconque des revendications précédentes, dans lequel le moyen de commande est configuré de façon à régler la sortie de la diode laser (2) de façon à fournir un balayage à des étapes discrètes de longueurs d'onde.

**7.** Analyseur spectroscopique comprenant un système de syntonisation thermique de laser (10) selon l'une quelconque des revendications précédentes, et comprenant en outre :

une chambre de mesure analytique pour recevoir, en cours d'utilisation, un échantillon à analyser ; et
un composant de réception de lumière pour recevoir la lumière du système qui est passée à travers la chambre à échantillon pour déterminer la nature de l'échantillon.

*FIG. 1*

FIG. 2a

FIG. 2b

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2011119342 A